(19) **Europäisches Patentamt**
**European Patent Office**
**Office européen des brevets**

(11) **EP 2 509 741 B1**

(12) **EUROPÄISCHE PATENTSCHRIFT**

(45) Veröffentlichungstag und Bekanntmachung des Hinweises auf die Patenterteilung:
**03.12.2014 Patentblatt 2014/49**

(21) Anmeldenummer: **10771088.1**

(22) Anmeldetag: **21.10.2010**

(51) Int Cl.:
**B23K 26/067** (2006.01)    **B23K 26/073** (2006.01)
**B23K 26/40** (2014.01)    **B23K 26/06** (2014.01)
**B23K 26/36** (2014.01)    **H01L 21/268** (2006.01)
**H01L 21/78** (2006.01)    **H01L 33/00** (2010.01)

(86) Internationale Anmeldenummer:
**PCT/EP2010/065891**

(87) Internationale Veröffentlichungsnummer:
**WO 2011/069735 (16.06.2011 Gazette 2011/24)**

(54) **VERFAHREN UND VORRICHTUNG FÜR EIN LASERABHEBEVERFAHREN MIT EINEM STRAHLTEILER**

METHOD AND DEVICE FOR A LASER LIFT-OFF METHOD HAVING A BEAM SPLITTER

PROCÉDÉ ET DISPOSITIF POUR UN PROCÉDÉ D'ABLATION À LASER AVEC UN DIVISEUR DE FAISCEAU

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.12.2009 DE 102009057566**

(43) Veröffentlichungstag der Anmeldung:
**17.10.2012 Patentblatt 2012/42**

(73) Patentinhaber: **OSRAM Opto Semiconductors GmbH**
**93055 Regensburg (DE)**

(72) Erfinder: **WAGNER, Ralph**
**93073 Neutraubling (DE)**

(74) Vertreter: **Epping - Hermann - Fischer Patentanwaltsgesellschaft mbH**
**Schloßschmidstraße 5**
**80639 München (DE)**

(56) Entgegenhaltungen:
**CN-Y- 2 432 001**         **US-A- 5 786 560**
**US-A1- 2006 246 687**    **US-A1- 2006 246 693**

**Beschreibung**

Es wird eine Vorrichtung für ein Laserabhebeverfahren angegeben. Darüber hinaus wird ein Laserabhebeverfahren angegeben.

Die Druckschrift US 5,786,560 A betrifft eine dreidimensionale Materialbearbeitung mit Femtosekunden-Laserimpulsen.

In der Druckschrift US 2006/0246687 A1 auf der der Oberbegriff der Ansprüche 1 und 9 basiert, ist ein Verfahren zur Herstellung eines Halbleiterbauteils angegeben.

Ein Laserinterferenz-Photoätzsystem findet sich in der Druckschrift CN 2432001 (Y).

Eine Beschreibung eines Herstellungsverfahrens eines Halbleiterbauteils mittels Laserstrahlung ist in der Druckschrift US 2006/0246693 A1 wiedergegeben.

Eine zu lösende Aufgabe besteht darin, eine Vorrichtung für ein Laserabhebeverfahren anzugeben, mit der effizient und zuverlässig eine Schicht von einem Träger abtrennbar ist. Insbesondere besteht eine zu lösende Aufgabe darin, ein Laserabhebeverfahren anzugeben, bei dem eine Halbleiterschichtenfolge zuverlässig von einem Träger entfernbar ist.

Diese Aufgaben werden gelöst durch eine Vorrichtung und ein Laserabhebeverfahren mit den Merkmalen der unabhängigen Patentansprüche.

Gemäß zumindest einer Ausführungsform der Vorrichtung ist diese für ein Laserabhebeverfahren geeignet, insbesondere zum Abtrennen einer auf einem Epitaxiesubstrat epitaktisch gewachsenen Halbleiterschicht oder Halbleiterschichtenfolge. Die Schicht oder die Halbleiterschicht basiert bevorzugt auf einem nitridhaltigen oder oxidhaltigen Material, insbesondere einem nitridhaltigen Halbleitermaterial. Zum Beispiel basiert die Halbleiterschichtenfolge auf GaN, InGaN und/oder AlGaN.

Gemäß zumindest einer Ausführungsform der Vorrichtung umfasst diese einen Laser zur Erzeugung einer bevorzugt gepulsten Laserstrahlung. Eine Wellenlänge der Laserstrahlung ist zum Beispiel so kurzwellig, so dass eine Photonenenergie größer ist als eine Bandlücke eines Halbleitermaterials, das von dem Träger abzutrennen ist. Beispielsweise liegt eine Wellenlänge der Laserstrahlung im ultravioletten Spektralbereich, insbesondere bei Wellenlängen kleiner als 400 nm oder kleiner als 360 nm.

Gemäß zumindest einer Ausführungsform der Vorrichtung weist diese zumindest einen Strahlteiler auf, bevorzugt mindestens zwei Strahlteiler. Der mindestens eine Strahlteiler ist dazu eingerichtet, die von dem Laser erzeugte insbesondere gepulste Laserstrahlung in mindestens zwei Teilstrahlen aufzuteilen. Bei den Strahlteilern kann es sich ebenso um insbesondere dielektrische, teildurchlässige Strahlteiler beziehungsweise Spiegel handeln, wie auch um Prismen und/oder um polarisationsabhängig reflektierende Elemente. Das heißt, im Betrieb der Vorrichtung wird die Laserstrahlung durch den mindestens einen Strahlteiler in wenigstens zwei Teilstrahlen aufgeteilt.

Gemäß zumindest einer Ausführungsform der Vorrichtung werden die mindestens zwei Teilstrahlen in einer Bestrahlungsebene überlagert. Mit anderen Worten wird die Laserstrahlung in mehrere Teilstrahlen aufgeteilt und anschließend in der Bestrahlungsebene wieder zum Überlappen gebracht. Dass sich die Teilstrahlen in der Bestrahlungsebene überlagern, kann bedeuten, dass Querschnitte der Teilstrahlen in der Bestrahlungsebene teilweise oder vollständig deckungsgleich sind. Deckungsgleich kann einschließen, dass einer der Querschnitte vollständig von einem anderen der Querschnitte umfasst oder überdeckt ist.

Gemäß zumindest einer Ausführungsform der Vorrichtung ist die Bestrahlungsebene dazu vorgesehen, dass darin eine der von dem Träger abzutrennenden Schicht abgewandte Hauptseite des Trägers angeordnet ist. Die Vorrichtung kann hierfür eine Halterung aufweisen, mit der der Träger mit der Schicht halterbar ist. Die Halterung ist bevorzugt in lateraler Richtung positionierbar und verfahrbar.

Gemäß zumindest einer Ausführungsform der Vorrichtung beträgt ein Winkel zwischen den mindestens zwei Teilstrahlen an der Bestrahlungsebene mindestens 1,0°. Bevorzugt beträgt der Winkel mindestens 5,0°. Mit anderen Worten schneiden Strahlachsen der Teilstrahlen die Bestrahlungsebene derart, dass ein Winkel zwischen den Strahlachsen der Teilstrahlen, insbesondere paarweise, mindestens 1,0°, bevorzugt mindestens 5,0° beträgt.

In mindestens einer Ausführungsform der Vorrichtung ist diese für ein Laserabhebeverfahren zum Abtrennen zumindest einer Schicht von einem Träger vorgesehen. Die Vorrichtung beinhaltet einen Laser zur Erzeugung einer zum Beispiel gepulsten Laserstrahlung sowie wenigstens einen Strahlteiler. Mittels des wenigstens einen Strahlteilers wird die Laserstrahlung in mindestens zwei Teilstrahlen aufgeteilt. Die Teilstrahlen werden in einer Bestrahlungsebene überlagert, wobei die Bestrahlungsebene dazu vorgesehen ist, dass darin eine der Schicht abgewandte Hauptseite des Trägers angeordnet ist. An der Bestrahlungsebene beträgt ein Winkel zwischen den mindestens zwei Teilstrahlen mindestens 1,0°.

Wird bei einem Laserabhebeverfahren, englisch Laser-Lift-Off, eine kohärente, gerichtete Laserstrahlung verwendet, so kann beim Durchtritt durch eine insbesondere raue Eintrittsfläche etwa eines Trägers an einer zum Beispiel einige hundert Mikrometer darunter liegenden Grenzfläche ein Interferenzmuster entstehen. Dieses Interferenzmuster weist statistisch verteilte, ortsfeste Intensitätsmodulationen des durchtretenden Laserstrahls auf. Allerdings können durch die interferenzfähige Laserstrahlung bei Verwendung eines kostengünstigeren Trägers mit einer nicht polierten, rauen Eintrittsfläche beim Laser-Lift-Off Schäden an der epitaktisch gewachsenen Halbleiterschichtenfolge entstehen. Um eine gleichmäßige Abtrennung beispielsweise der Halbleiterschichtenfolge von dem Träger zu gewährleisten, hat es sich nun als vorteilhaft herausgestellt, derartige Intensitätsmodulationen zu vermeiden oder zu reduzieren.

Durch ein Aufteilen der Laserstrahlung in wenigstens zwei Teilstrahlen und dem anschließenden Überlagern der Teilstrahlen unter einem bestimmten Winkel, der größer ist als ein kritischer Winkel, lässt sich die Interferenzfähigkeit der Laserstrahlung reduzieren, wodurch Intensitätsmodulationen eines Interferenzmusters reduzierbar und Schäden an der Halbleiterschichtenfolge vermeidbar oder verminderbar sind.

Gemäß zumindest einer Ausführungsform der Vorrichtung weisen mindestens zwei der Teilstrahlen und/oder weisen alle Teilstrahlen, mit einer Toleranz von höchstens 20 %, insbesondere mit einer Toleranz von höchstens 10 %, gleiche Intensitäten auf. Mit anderen Worten weisen beide und/oder alle Teilstrahlen pro Laserimpuls eine im Wesentlichen gleiche Energie auf. Mit zunehmender Anzahl der Teilstrahlen kann die Toleranz der Energien pro Impuls aber auch größer werden. Beispielsweise nimmt die Impulsenergietoleranz pro zusätzlichem Teilstrahl um 5 Prozentpunkte zu, wobei die Toleranz jedoch maximal 50 % beträgt.

Gemäß zumindest einer Ausführungsform der Vorrichtung liegt eine Impulsdauer der Laserstrahlung bei höchstens 50 ns. Beispielsweise handelt es sich bei der Laserstrahlung um Nanosekundenimpulse mit Impulsdauern zwischen einschließlich 1 ns und 15 ns, insbesondere zwischen einschließlich 3 ns und 10 ns.

Gemäß zumindest einer Ausführungsform der Vorrichtung entspricht ein optischer Weglängenunterschied zwischen den Teilstrahlen höchstens dem 0,05-fachen oder höchstens dem 0,15-fachen, insbesondere höchstens dem 0,025-fachen der mittleren Impulsdauer der Laserstrahlung. Mit anderen Worten sind die Lichtimpulse der Teilstrahlen dazu eingerichtet, im Wesentlichen zeitgleich auf den Träger aufzutreffen. Bevorzugt ist der Weglängenunterschied höchstens so groß, dass mindestens 80 % oder mindestens 90 % der Summe der Energien pro Impuls aller Teilstrahlen in einem Zeitfenster an die Bestrahlungsebene gelangen, das eine Länge von höchstens dem 1,22-fachen oder 1,15-fachen der mittleren Impulsdauer, bevorzugt von höchstens der mittleren Impulsdauer aufweist. Die Impulsdauer ist bevorzugt bezogen auf einen Abfall der Intensität auf 1/e einer maximalen Intensität des zeitlichen Verlaufs der Impulse.

Gemäß zumindest einer Ausführungsform der Vorrichtung entspricht ein optischer Weglängenunterschied zwischen den Teilstrahlen mindestens dem 0,025-fachen und höchstens dem 0,3-fachen der mittleren Impulsdauer der Laserstrahlung. Mit anderen Worten gelangen die Lichtimpulse der Teilstrahlen zu leicht unterschiedlichen Zeiten an der Bestrahlungsebene an.

Gemäß zumindest einer Ausführungsform der Vorrichtung beträgt ein Weglängenunterschied zwischen den Teilstrahlen höchstens dem 0,22-fachen oder dem 0,15-fachen eines mittleren Strahldurchmessers der Teilstrahlen. Der Strahldurchmesser ist insbesondere bezogen auf einen Abfall der räumlichen, lateralen Intensitätsverteilung auf $1/e^2$ einer maximalen Intensität des Strahlprofils.

Gemäß zumindest einer Ausführungsform der Vorrichtung beträgt ein Winkel zwischen den Teilstrahlen, bevorzugt paarweise, jeweils zwischen einschließlich 7,5° und 50°. Alternativ oder zusätzlich liegt ein Winkel zwischen den Teilstrahlen und einem Lot zu der Bestrahlungsebene jeweils zwischen einschließlich 0° und 80°, insbesondere zwischen einschließlich 0° und 30°.

Gemäß zumindest einer Ausführungsform der Vorrichtung wird die Laserstrahlung in N Teilstrahlen aufgeteilt und die Vorrichtung umfasst N - 1 Strahlteiler. N ist hierbei eine ganze Zahl, bevorzugt zwischen einschließlich 3 und 8. Für eine Reflektivität R des N-ten Strahlteilers gilt der Zusammenhang:

$$R(N) = 1 / (N+1)$$

Der Strahlteiler mit der höchsten Reflektivität befindet sich hierbei, bezogen auf einen Strahlengang der Laserstrahlung oder der Teilstrahlen, am nächsten an der Bestrahlungsebene, der Strahlteiler mit der zweithöchsten Reflektivität befindet sich am zweitnächsten an der Bestrahlungsebene und so weiter.

Gemäß zumindest einer Ausführungsform der Vorrichtung befindet sich in den Strahlwegen der Teilstrahlung zwischen dem jeweiligen, zugeordneten Strahlteiler und der Bestrahlungsebene keine zu einer Strahlungstransmission vorgesehene optische Komponente. Bevorzugt befindet sich in den Strahlengängen der Teilstrahlen also keine Linse oder Polarisationsoptik. Mit anderen Worten durchlaufen die Teilstrahlen ab dem zugeordneten Strahlteiler bis zur Bestrahlungsebene bevorzugt keine kondensierte Materie mehr.

Gemäß zumindest einer Ausführungsform der Vorrichtung weisen die Teilstrahlen in der Bestrahlungsebene, mit einer Toleranz von höchstens 15 %, insbesondere mit einer Toleranz von höchstens 10 %, jeweils gleiche Querschnittsflächen und/oder gleiche laterale Ausdehnungen auf. Mit anderen Worten sind die Querschnitte der Teilstrahlen in der Bestrahlungsebene im Wesentlichen gleich groß und im Wesentlichen gleich geformt.

Gemäß der Erfindung beträgt eine Summe der Energiedichten aller Teilstrahlen in der Bestrahlungsebene zwischen einschließlich 200 mJ/cm$^2$ und 850 mJ/cm$^2$ pro Impuls der Laserstrahlung.

Darüber hinaus wird ein Laserabhebeverfahren zum Abtrennen einer epitaktisch gewachsenen Halbleiterschichtenfolge von einem Träger, insbesondere von einem Aufwachssubstrat, angegeben. Das Abhebeverfahren kann mit einer Vorrichtung, wie in Verbindung mit mindestens einer der oben genannten Ausführungsformen beschrieben, durchgeführt werden. Merkmale des Laserabhebeverfahrens sind daher auch für die hier beschriebene Vorrichtung offenbart und umgekehrt.

In mindestens einer Ausführungsform des Laserabhebeverfahrens umfasst dieses die Schritte:

- Bereitstellen der epitaktisch auf dem Träger gewachsenen Halbleiterschichtenfolge,
- Aufteilen einer insbesondere gepulsten Laserstrahlung in mindestens zwei Teilstrahlen, und
- Überlagern der Teilstrahlen in einer Bestrahlungsebene, in der sich eine der Halbleiterschichtenfolge abgewandte Hauptseite des Trägers befindet.

Ein Winkel zwischen den mindestens zwei Teilstrahlen zueinander an der Bestrahlungsebene beträgt hierbei mindestens 1,0°.

Gemäß zumindest einer Ausführungsform des Laserabhebeverfahrens beträgt eine mittlere Rauheit der der Halbleiterschichtenfolge abgewandten Hauptfläche des Trägers zwischen einschließlich 0,1 $\mu$m und 5,0 $\mu$m, insbesondere zwischen einschließlich 0,25 $\mu$m und 2,5 $\mu$m. Beispielsweise bei einem epitaktischen Wachsen einer Halbleiterschichtenfolge ist ein Substrat mit einer polierten und einer rauen Oberfläche einsetzbar. Hierdurch sind kostengünstigere Substrate verwendbar.

Gemäß zumindest einer Ausführungsform des Laserabhebeverfahrens umfasst der Träger Saphir oder besteht hieraus. Alternativ kann der Träger aus einem anderen, für die Laserstrahlung klarsichtigen oder transparenten Material bestehen. Transparent kann heißen, dass der Träger eine Absorption von höchstens 20 % oder von höchstens 1 %, bevorzugt von höchstens 0,2 % bei der Wellenlänge der Laserstrahlung und der Teilstrahlung aufweist.

Gemäß zumindest einer Ausführungsform des Laserabhebeverfahrens basiert die Halbleiterschichtenfolge auf Galliumnitrid, Indiumgalliumnitrid und/oder Aluminiumgalliumnitrid. Alternativ ist es möglich, dass eine abzutrennende Schicht ein anderes, insbesondere oxidhaltiges oder nitridhaltiges Material wie Siliziumnitrid aufweist, das bei der Wellenlänge der Laserstrahlung eine hohe Absorption aufweist.

Darüber hinaus wird eine Nitrid-Halbleiterschichtenfolge, insbesondere auf Galliumnitrid basierend, angegeben. Die Halbleiterschichtenfolge ist zum Beispiel mit einer Vorrichtung oder mit einem Verfahren hergestellt, wie in Verbindung mit einer oder mehrerer der oben genannten Ausführungsformen angegeben. Merkmale für die Halbleiterschichtenfolge sind daher auch für das Verfahren sowie für die Vorrichtung offenbart und umgekehrt.

Neben einem Laserabhebeverfahren ist es auch möglich, dass eine hier beschriebenen Vorrichtung und eine Abwandlung eines hier beschriebenen Verfahrens zu einer auf einer mikroskopischen Skala homogenen Ausleuchtung einer Schicht durch eine raue Oberfläche hindurch eingesetzt wird, wobei die Schicht von der rauen Oberfläche beabstandet ist. Beispielsweise ist eine homogene Belichtung eines Fotolacks in einem lithographischen Verfahren oder eine homogene Ausleuchtung bei einem strahlungsinduzierten Härten eines Verbindungsmittels, wie einem UV-aushärtendem Kleber, durch raue Oberflächen hindurch realisierbar.

Nachfolgend wird ein hier beschriebenes Laserabhebeverfahren, eine hier beschriebene Halbleiterschichtenfolge sowie eine hier beschriebene Vorrichtung unter Bezugnahme auf die Zeichnung anhand von Ausführungsbeispielen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:

Figuren 1, 2, 4, 7 und 8      schematische Ausführungsbeispiele von hier beschriebenen Vorrichtungen, an denen ein hier beschriebenes Laserabhebeverfahren durchführbar ist,

Figuren 3 und 5      schematische Ausführungsbeispiele von hier beschriebenen Halbleiterschichtenfolgen, und

Figur 6      schematische Draufsichten auf Hauptseiten eines Trägers bei einem hier beschriebenen Laserabhebeverfahren.

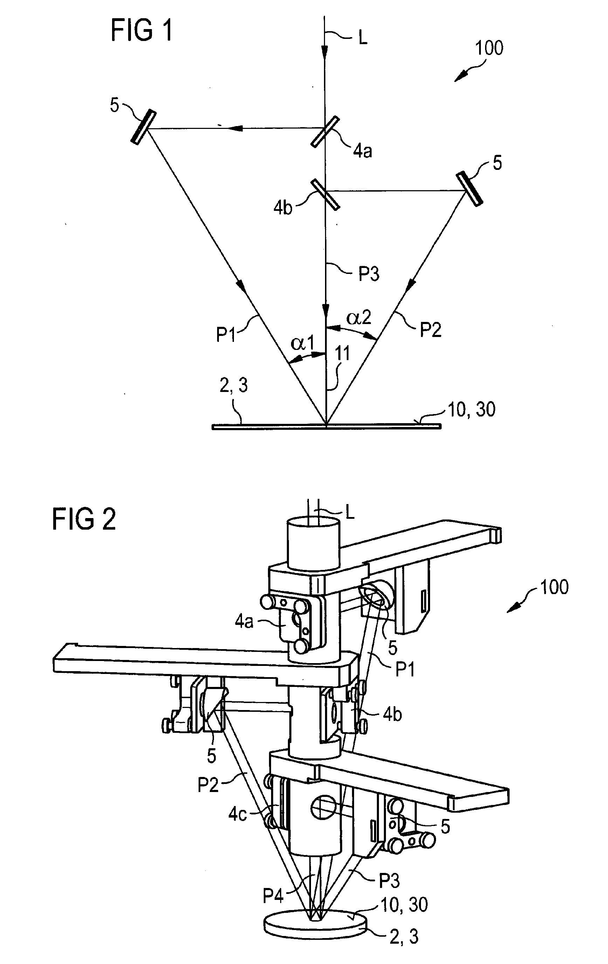

In Figur 1 ist ein Ausführungsbeispiel einer Vorrichtung 100 dargestellt, mit der ein Laserabhebeverfahren durchgeführt wird. Ein in Figur 1 nicht gezeigter Laser emittiert eine gepulste Laserstrahlung L. Mittels zwei Strahlteilern 4a, 4b wird die Laserstrahlung in drei Teilstrahlen P1, P2, P3 aufgeteilt, wobei der Teilstrahl P3 die um die Teilstrahlen P1, P2 verminderte Laserstrahlung L ist. Die Teilstrahlen P1, P2, P3 und die Laserstrahlung L weisen zum Beispiel näherungsweise gaußförmige Strahlprofile mit einem Durchmesser von 1/e$^2$, bezogen auf einen Abfall der Intensität der Strahlung in lateraler Richtung hinsichtlich einer maximalen Intensität, zwischen einschließlich 2 mm und 8 mm, insbesondere um 4 mm, auf. Eine Wellenlänge beträgt beispielsweise zirka 343 nm oder zirka 355 nm.

Die Teilstrahlen P1, P2 werden über Spiegel 5 mit der nicht abgelenkten Teilstrahlung P3 in einer Bestrahlungsebene 10 überlagert. Ein Winkel α1, α2 zwischen den Teilstrahlen P1, P3 und P2, P3 beträgt jeweils zirka 30°. Die Winkel α1, α2 sind auch gleich einem Winkel zu einem Lot 11 der Bestrahlungsebene 10. Das Lot 11 fällt mit einer Strahlachse der Teilstrahlung P3 und der Laserstrahlung L zusammen.

Die Bestrahlungsebene 10 ist dazu eingerichtet, dass mittels eines in Figur 1 nicht dargestellten Halters ein Träger 2 mit einer Schicht 2 oder mit einer Halbleiterschichtenfolge 2 mit einer der Schicht 2 abgewandten Hauptseite 30 des Trägers 3 in der Bestrahlungsebene 10 zu liegen kommt. Die Hauptseite 30 des Trägers 3 weist bevorzugt eine Rauheit zwischen einschließlich 0,5 μm und 1,5 μm, beispielsweise mit einer Rauheit von ungefähr 1 μm, auf.

Strahlwege der Teilstrahlen P1, P2, P3, jeweils gerechnet ab dem Strahlteiler 4a bis zur Bestrahlungsebene 10, unterscheiden sich voneinander in ihrer Länge. Beispielsweise ist der Strahlweg des Teilstrahls P2 um zirka 15 cm länger als der Strahlweg des Teilstrahls P3. Der Strahlweg des Teilstrahls P1 ist beispielsweise um zirka 30 cm länger als der Strahlweg des Teilstrahls P3. Beträgt eine Impulsdauer der Laserstrahlung L beispielsweise zirka 5 ns, so entspricht ein optischer Weglängenunterschied zwischen den Teilstrahlen P1, P3 zirka einem 0,2-fachen der Impulsdauer. Mit anderen Worten treffen die Impulse der Teilstrahlen P1, P2, P3 zu unterschiedlichen Zeiten auf den Träger 3 auf.

Anders als in Figur 1 dargestellt ist es möglich, dass insbesondere die Teilstrahlen P2 und P3 so geführt werden, dass die einzelnen Impulse der Teilstrahlen P1, P2, P3 im Wesentlichen zeitgleich die Bestrahlungsebene 10 erreichen. Jedoch ist durch ein Ankommen der Impulse der Teilstrahlen P1, P2, P3 zu moderat unterschiedlichen Zeiten an der Bestrahlungsebene 10 eine Interferenzfähigkeit der Laserstrahlung L beziehungsweise der Teilstrahlen P1, P2, P3 an der Bestrahlungsebene 10 reduzierbar.

In Figur 2 ist ein weiteres Ausführungsbeispiel der Vorrichtung 100, mit der das Laserabhebeverfahren durchführbar ist, dreidimensional dargestellt. Die Laserstrahlung L wird in die vier Teilstrahlen P1, P2, P3, P4 aufgeteilt. Die Teilstrahlen P1, P2, P3 sind rotationssymmetrisch um die nicht abgelenkte Teilstrahlung P4 angeordnet. Die Winkel, unter denen die Teilstrahlen P2, P3, P4 auf die Hauptseite 30 des Trägers 3 treffen, sind zum Beispiel paarweise voneinander verschieden.

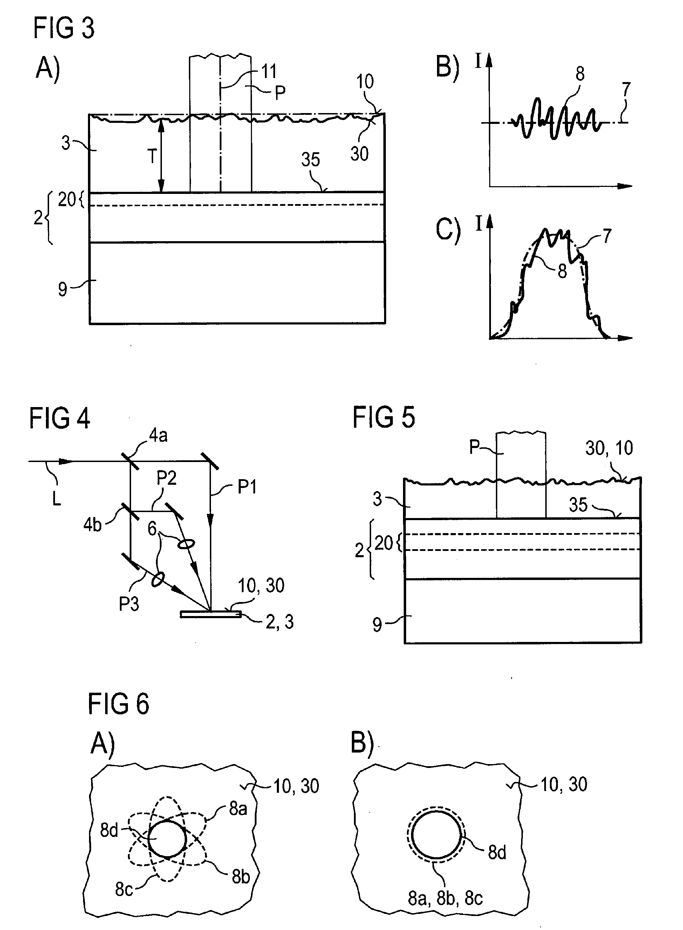

In einer Schnittdarstellung ist in Figur 3A das Halbleiterbauteil dargestellt. Die Halbleiterschichtenfolge 2, die bevorzugt epitaktisch auf dem Träger 3 gewachsen ist, ist nach dem epitaktischen Wachsen weiterhin an einem Substrat 9 angebracht. Verbindungsschichten zwischen dem Substrat 9 und der Halbleiterschichtenfolge 2 sind in den Figuren nicht gezeichnet. Der Träger 3 besteht zum Beispiel aus Saphir und weist eine Dicke bevorzugt zwischen einschließlich 250 μm und 1,5 mm auf, insbesondere eine Dicke um zirka 650 μm.

Eine Zersetzungszone 20 der Halbleiterschichtenfolge 2 an einer dem Substrat 9 zugewandten Hauptseite 35 des Trägers 3 absorbiert die Teilstrahlungen P. Eine Dicke der Halbleiterschichtenfolge 2 insgesamt beträgt zum Beispiel höchstens 12 μm, insbesondere um zirka 6 μm. Durch die Absorption der Teilstrahlungen P erfolgt eine thermische Zersetzung des Materials der Zersetzungszone 20. Durch ein Abrastern der Halbleiterschichtenfolge 2 sowie des Trägers 3 in lateraler Richtung durch die Teilstrahlen P1, P2, P3, P4 ist die Halbleiterschichtenfolge 2 von dem Träger 3 abtrennbar. Eine Energiedichte aller Teilstrahlen P1, P2, P3, P4 pro Impuls beträgt insgesamt zum Beispiel zirka 400 mJ/cm$^2$ und liegt bevorzugt knapp unterhalb einer Zerstörschwelle eines Materials der Zersetzungszone 20.

In den Figuren 3B und 3C ist eine Intensität I der Teilstrahlung P in lateraler Richtung schematisch aufgetragen. Gemäß Figur 3B weist die Teilstrahlung P eine rechteckförmige Einhüllende 7 eines realen Strahlprofils 8 der Teilstrahlung P auf, gemäß Figur 3C ist die Einhüllende 7 gaußförmig. Das reale Strahlprofil 8 weicht von der Einhüllenden 7 aufgrund von Interferenzeffekten ab. Diese Abweichungen können zu einem ungleichmäßigen Ablösen der Halbleiterschichtenfolge 2 von dem Träger 3 und damit zu einer Beschädigung der Halbleiterschichtenfolge 2 führen. Durch die Aufteilung der Laserstrahlung L in mindestens zwei der Teilstrahlen P sind die Intensitätsmodulationen des realen Strahlprofils 8 um die Einhüllende 7 reduzierbar, so dass ein effizientes und zuverlässiges Ablösen der Halbleiterschichtenfolge 2 von dem Träger 3 mittels der Vorrichtung und mittels des Verfahrens realisierbar ist. Zum Beispiel betragen die Abweichungen der Einhüllenden 7 von dem realen Strahlprofil 8 höchstens 20 %, bevorzugt höchstens 10 %.

Eine Größe der Intensitätsmodulation des realen Strahlprofils 8 gegenüber der Einhüllenden 7 kann beispielsweise über eine Rauheit der Halbleiterschichtenfolge 2 nach dem Abtrennen von dem Träger 3 nachweisbar sein. Wird die Zersetzungszone 20 beispielsweise über ein Ätzen von der Halbleiterschichtenfolge 2 nach dem Abtrennen von dem Träger 3 entfernt, so kann die Intensitätsmodulation des realen Strahlprofils 8 über eine nach dem Ätzen resultierende Struktur der Halbleiterschichtenfolge 2 an einer dem Substrat 9 abgewandten Seite nachweisbar sein.

Beim Ausführungsbeispiel gemäß Figur 4 durchlaufen die Teilstrahlungen P2, P3 jeweils eine optische Komponente 6. Die optische Komponente 6 ist zum Beispiel eine Zylinderlinse, mit der ein Querschnitt der Teilstrahlen P2, P3 in der Bestrahlungsebene 10 an einen Querschnitt des Teilstrahls P1, der senkrecht auf die Bestrahlungsebene 10 trifft, anpassbar ist, vergleiche auch Figur 6B. Bis auf die zur Strahlkorrektur eingerichtete optische Komponente 6 durchlaufen die Teilstrahlen P1, P2, P3 nach dem jeweils zugeordneten Strahlteiler 4a, 4b bis zur Bestrahlungsebene 10 bevorzugt jeweils keine weitere kondensierte Materie.

Gemäß Figur 5 weist die Halbleiterschichtenfolge 2 die Zersetzungszone 20 nicht direkt an der dem Substrat 9 zugewandten Hauptseite 35 des Trägers 3 auf. Mit anderen Worten ist es möglich, mit dem hier beschriebenen Verfahren ein teilweises Abheben der Halbleiterschichtenfolge 2 zu realisieren. Abweichend hiervon ist es alternativ oder zusätzlich ebenso möglich, dass der Träger 3 eine nicht gezeichnete Teilschicht oder einen Bereich aufweist, der eine erhöhte Absorption für die Teilstrahlung P aufweist, so dass dann nach dem Abtrennen auch ein Teil des Trägers 3 an der Halbleiterschichtenfolge 2 verbleiben kann.

Die Halbleiterschichtenfolge 2 basiert beispielsweise auf Galliumnitrid. Ebenso ist es möglich, dass die Zersetzungszone 20 ein anderes, ein Nitrid beinhaltendes Material aufweist. Beispielsweise kann die Zersetzungszone 20 aus Siliziumnitrid bestehen oder dieses aufweisen.

In den Figuren 6A und 6B sind Draufsichten auf die Bestrahlungsebene 10 sowie die Hauptseite 30 dargestellt. Ferner sind die Strahlprofile 8a, 8b, 8c, 8d der Teilstrahlen P1, P2, P3, P4 dargestellt, die beispielsweise durch die Vorrichtung 100 gemäß Figur 2 in der Bestrahlungsebene 10 vorliegen. Dadurch, dass die Teilstrahlen P1, P2, P3 unter einem vergleichsweise großen Winkel zum Lot 11 der Bestrahlungsebene 10 auf diese auftreffen, weisen die Teilstrahlen P1, P2, P3 in der Bestrahlungsebene 10 unterschiedliche Querschnitte auf.

In Figur 6B ist dargestellt, dass die Querschnitte in der Bestrahlungsebene 10 gleiche oder im Wesentlichen gleiche Querschnittsflächen und laterale Ausdehnungen aufweisen. Dies ist durch insbesondere reflektive Optiken, beispielsweise durch entsprechend geformte Spiegel 5 oder durch die optische Komponente 6 in den Strahlgängen der Teilstrahlen P1, P2, P3, realisierbar. Bevorzugt liegen innerhalb eines Kreises mit einem Radius des mittleren oder des kleinsten Strahldurchmessers der Teilstrahlen P1, P2, P3, bezogen auf einen Abfall der Intensität auf $1/e^2$, mindestens 80 % oder mindestens 90 % der gesamten Energie der Teilstrahlen P1, P2, P3.

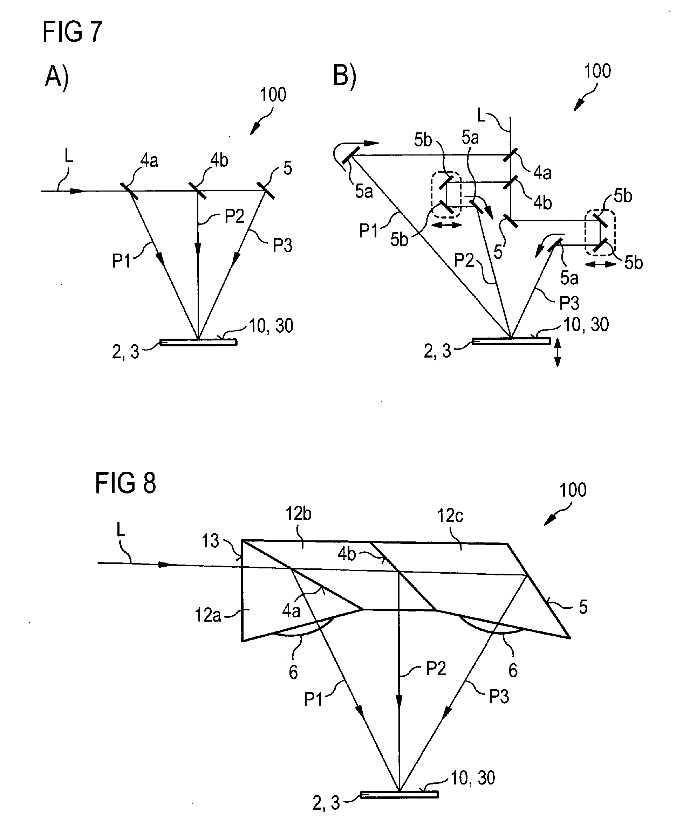

In den Figuren 7A und 7B sind weitere Ausführungsbeispiele der Vorrichtung 100 dargestellt. Gemäß Figur 7B sind die drei Spiegel 5a um eine horizontale Achse drehbar, so dass der Winkel, unter dem die Teilstrahlen P1, P2, P3 auf die Hauptseite 30 auftreffen, einstellbar ist. Ebenso kann der Träger 3 mit der Halbleiterschichtenfolge 2 optional in vertikaler Richtung verschoben werden. Über die beweglichen Spiegel 5b sind Strahlwege der Teilstrahlen P2, P3 einstellbar, so dass eine zeitliche Verzögerung zwischen den Teilstrahlen P1, P2, P3 einstellbar ist.

Beim Ausführungsbeispiel gemäß Figur 8 sind die Strahlteiler 4a, 4b durch Prismen 12a, 12b, 12c implementiert, die zum Beispiel aus Quarzglas gebildet sind. Die Prismen 12a, 12b, 12c sind entweder aneinander gekittet oder, bevorzugt, durch dünne Luftspalte voneinander separiert. Die Strahlteiler 4a, 4b sind dann teilreflektierende Begrenzungsflächen der Prismen 12a, 12b. Der Strahlteiler 4a weist eine Reflektivität von zirka 33 % auf und der Strahlteiler 4b von zirka 50 %. Die Reflektivität ist beispielsweise durch Beschichtungen auf den entsprechenden Begrenzungsflächen der Prismen 12a, 12b durch einen Winkel der entsprechenden Begrenzungsflächen der Prismen 12a, 12b, 12c, durch eine Polarisation der Strahlung und/oder durch eine Dicke eines Spalts zwischen benachbarten Prismen 12a, 12b, 12c einstellbar.

An den Prismen 12a, 12c sind optional die optischen Komponenten 6, die als Zylinderlinsen gestaltet sind, entweder angebracht oder bereits einstückig mit den Prismen 12a, 12c hergestellt. Über die Zylinderlinsen wird erreicht, dass die Teilstrahlen P1, P2, P3 in der Bestrahlungsebene 10 gleiche Strahlquerschnitte aufweisen, siehe auch Figur 6B. Der Spiegel 5 kann durch eine totalreflektierende Begrenzungsfläche des Prismas 12c oder durch eine hochreflektierende Beschichtung gebildet sein. Das Prisma 12a weist bevorzugt eine Antireflexionsbeschichtung 13 an einer Strahlungseintrittsfläche auf. Bei der Verwendung von Femtosekundenimpulsen oder von Pikosekundenimpulsen können in Figur 8 nicht gezeichnete Vorrichtungen zu einer Korrektur eines zeitlichen Farbverlaufs in den Impulsen der Teilstrahlen P1, P2, P3, englisch auch als Chirp bezeichnet, vorgesehen sein.

Die hier beschriebene Erfindung ist nicht durch die Beschreibung anhand der Ausführungsbeispiele beschränkt.

## Patentansprüche

**1.** Vorrichtung (100) für ein Laserabhebeverfahren zum Abtrennen zumindest einer Schicht (2) von einem Träger (3) mit

- einem Laser zur Erzeugung einer Laserstrahlung (L), wobei die Laserstrahlung eine gepulste Laserstrahlung (L) mit Nanosekundenimpulsen ist und eine Impulsdauer der Laserstrahlung (L), zwischen einschließlich $I_{ns}$ und höchstens 50 ns beträgt, wobei ein optischer Weglängenunterschied zwischen den Teilstrahlen (P) mindestens dem 0,025-fachen und höchstens dem 0,25-fachen der Impulsdauer entspricht, und wobei eine Energiedichte aller Teilstrahlen (P) zusammen in der Bestrahlungsebene (10) zwischen einschließlich 200 mJ/cm$^2$ und 850 mJ/cm$^2$ pro Impuls beträgt, und **gekennzeichnet durch** - wenigstens einen Strahlteiler (4), und **dadurch** gekennzeichnet, dass
- die Laserstrahlung (L) mittels des wenigstens einen Strahlteilers (4) in mindestens zwei Teilstrahlen (P) aufgeteilt ist,

- die mindestens zwei Teilstrahlen (P) in einer Bestrahlungsebene (10) überlagert werden,
- die Bestrahlungsebene (10) dazu vorgesehen ist, dass darin eine der Schicht (2) abgewandte Hauptseite (30) des Trägers (3) angeordnet ist, und
- ein Winkel ($\alpha$) zwischen den mindestens zwei Teilstrahlen (P) zueinander an der Bestrahlungsebene (10) mindestens 1,0° beträgt.

2. Vorrichtung (100) nach dem vorhergehenden Anspruch, bei der alle Teilstrahlen (P), mit einer Toleranz von höchstens 20 %, eine gleiche Intensität aufweisen.

3. Vorrichtung (100) nach einem der vorhergehenden Ansprüche,
bei der sich in den Strahlwegen der Teilstrahlen (P) zwischen dem jeweiligen, zugeordneten Strahlteiler (4) und der Bestrahlungsebene (10) keine zu einer Strahlungstransmission vorgesehene optische Komponente befinden, sodass die Teilstrahlen (P) ab dem zugeordneten Strahlteiler (4) bis zur Bestrahlungsebene (10) keine kondensierte Materie durchlaufen.

4. Vorrichtung (100) nach einem der vorhergehenden Ansprüche,
bei der der Winkel ($\alpha$) zwischen den Teilstrahlen (P) jeweils zwischen einschließlich 7,5° und 50° und ein Winkel zwischen den Teilstrahlen (P) und einem Lot (11) der Bestrahlungsebene (10) jeweils zwischen einschließlich 0° und 50° liegt,
wobei eine Impulsdauer der Laserstrahlung (L) zwischen einschließlich 1 ns und 15 ns liegt.

5. Vorrichtung (100) nach einem der vorhergehenden Ansprüche,
bei der die Laserstrahlung (L) durch N-1 Strahlteiler (4) in N Teilstrahlen (P) aufgeteilt ist, wobei für eine Reflektivität R(N) des N-ten Strahlteilers (4) gilt:

$$R(N) = 1/(N+1),$$

wobei N eine ganze Zahl zwischen einschließlich 3 und 8 ist, und wobei die Strahlteiler (4) entlang eines Strahlenganges zu der Bestrahlungsebene (10) hin mit ansteigender Reflektivität angeordnet sind.

6. Vorrichtung (100) nach einem der vorhergehenden Ansprüche,
bei der die Teilstrahlen (P) zwischen dem jeweils zugeordneten Strahlteiler (4) und der Bestrahlungsebene (10) keine zu einer Strahlungstransmission vorgesehenen optischen Komponenten (6) durchlaufen.

7. Vorrichtung (100) nach einem der vorhergehenden Ansprüche,
bei der die Teilstrahlen (P) in der Bestrahlungsebene (10), mit einer Toleranz von höchstens 15 %, jeweils gleiche Querschnittsflächen und gleiche laterale Ausdehnungen aufweisen.

8. Vorrichtung (100) nach einem der vorhergehenden Ansprüche,
bei der die Teilstrahlen (P) und die Laserstrahlung (L) gaußförmige Strahlprofile aufweisen mit einem Durchmesser von $1/e^2$, bezogen auf einen Abfall der Intensität der Strahlung (L, P) in lateraler Richtung hinsichtlich einer maximalen Intensität, zwischen einschließlich 2 mm und 8 mm.

9. Laserabhebeverfahren zum Abtrennen einer epitaktisch gewachsenen Halbleiterschichtenfolge (2) von einem Träger (3) mit den Schritten:

- Bereitstellen der epitaktisch auf dem Träger (3) gewachsenen Halbleiterschicht (2) oder Halbleiterschichtenfolge (2), wobei, die Laserstrahlung eine gepulste Laserstrahlung (L) mit Nanosekundenimpulsen ist und eine Impulsdauer der Laserstrahlung (L) zwischen einschließlich $I_{ns}$ und höchstens 50 ns beträgt, wobei ein optischer Weglängenunterschied zwischen den Teilstrahlen (P) mindestens dem 0,025-fachen und höchstens dem 0,25-fachen der Impulsdauer entspricht,
wobei eine Energiedichte aller Teilstrahlen (P) zusammen in der Bestrahlungsebene (10) zwischen einschließlich 200 mJ/cm2 und 850 mJ/cm2 pro Impuls beträgt, und wobei eine mittlere Rauheit einer der Halbleiterschichtenfolge (2) abgewandten Hauptseite (30) des Trägers (3) zwischen einschließlich 0,1 $\mu$m und 5,0 $\mu$m beträgt
**gekennzeichnet durch**:

- Aufteilen einer Laserstrahlung (L) in mindestens zwei Teilstrahlen (P), und
- Überlagern der Teilstrahlen (P) in einer Bestrahlungsebene (10), in der sich eine der Halbleiterschichtenfolge (2) abgewandte Hauptseite (30) des Trägers (3) befindet, wobei ein Winkel ($\alpha$) zwischen den mindestens zwei Teilstrahlen (P) zueinander an der Bestrahlungsebene (10) mindestens 1,0° beträgt,

10. Laserabhebeverfahren nach dem vorhergehenden Anspruch, wobei eine Energiedichte aller Teilstrahlen (P) pro Impuls insgesamt unterhalb einer Zerstörschwelle eines Materials einer Zersetzungszone (20) der Halbleiterschichtenfolge (2) liegt.

11. Laserabhebeverfahren nach Anspruch 9 oder 10, wobei der Träger (3) Saphir umfasst oder hieraus besteht, und bei dem die Halbleiterschichtenfolge (2) auf GaN, InGaN und/oder AlGaN basiert.

12. Laserabhebeverfahren nach einem der Ansprüche 9 bis 11, wobei der Träger (3) eine Dicke (T) zwischen einschließlich 250 $\mu$m und 1,5 mm aufweist, und bei dem eine Intensitätsmodulation der überlagerten Teilstrahlen (P) an einer der Halbleiterschichtenfolge (2) zugewandten Aufwachsseite (35) des Trägers (3) höchstens 20 % beträgt, bezogen auf eine lokale Einhüllende (7) eines Strahlprofils (8) der überlagerten Teilstrahlen (P).

13. Laserabhebeverfahren nach einem der Ansprüche 9 bis 12, das mit einer Vorrichtung (100) nach einem der Ansprüche 1 bis 8 durchgeführt wird.

**Claims**

1. Device (100) for a laser lift-off method for separating at least one layer (2) from a carrier (3) comprising

   - a laser for generating a laser radiation (L), wherein the laser radiation is a pulsed laser radiation (L) comprising nanosecond pulses and a pulse duration of the laser radiation (L) is between 1 ns and at most 50 ns inclusive, wherein an optical path length difference between the partial beams (P) corresponds to at least 0.025 times and at most 0.25 times the pulse duration, and
   wherein an energy density of all the partial beams (P) together in the irradiation plane (10) is between 200 mJ/cm$^2$ and 850 mJ/cm$^2$ inclusive per pulse, and **characterized by**
   - at least one beam splitter (4), and
   **characterized in that**
   - the laser radiation (L) is split into at least two partial beams (P) by means of the at least one beam splitter (4),
   - the at least two partial beams (P) are superimposed in an irradiation plane (10),
   - the irradiation plane (10) is provided for a main side (30) of the carrier (3), said main side facing away from the layer (2), to be arranged therein, and
   - an angle ($\alpha$) between the at least two partial beams (P) with respect to one another at the irradiation plane (10) is at least 1.0°.

2. Device (100) according to the preceding claim, wherein all the partial beams (P), with a tolerance of at most 20%, have an identical intensity.

3. Device (100) according to either of the preceding claims, wherein no optical component provided for radiation transmission is situated in the beam paths of the partial beams (P) between the respective, assigned beam splitter (4) and the irradiation plane (10), such that the partial beams (P), starting from the assigned beam splitter (4) as far as the irradiation plane (10), do not pass through condensed matter.

4. Device (100) according to any of the preceding claims, wherein the angle ($\alpha$) between the partial beams (P) is in each case between 7.5° and 50° inclusive and an angle between the partial beams (P) and a perpendicular (11) relative to the irradiation plane (10) is in each case between 0° and 50° inclusive, wherein a pulse duration of the laser radiation (L) is between 1 ns and 15 ns inclusive.

5. Device (100) according to any of the preceding claims, wherein the laser radiation (L) is split into N partial beams (P) by N-1 beam splitters (4), wherein the following holds true for a reflectivity R(N) of the N-th beam splitter (4):

$$R(N) = 1/(N+1),$$

wherein N is an integer between 3 and 8 inclusive, and wherein the beam splitters (4) are arranged with rising reflectivity along a beam path towards the irradiation plane (10).

6. Device (100) according to any of the preceding claims,
wherein,
the partial beams (P), between the respectively assigned beam splitter (4) and the irradiation plane (10), pass through no optical components (6) provided for radiation transmission.

7. Device (100) according to any of the preceding claims,
wherein
the partial beams (P) in the irradiation plane (10), with a tolerance of at most 15%, have in each case identical cross-sectional areas and identical lateral extents.

8. Device (100) according to any of the preceding claims,
wherein the partial beams (P) and the laser radiation (L) have Gaussian beam profiles having a diameter of $1/e^2$, relative to a decrease in the intensity of the radiation (L, P) in a lateral direction with regard to a maximum intensity, between 2 mm and 8 mm inclusive.

9. Laser lift-off method for separating an epitaxially grown semiconductor layer sequence (2) from a carrier (3) comprising the following steps:

- providing the semiconductor layer (2) or semiconductor layer sequence (2) grown epitaxially on the carrier (3), wherein the laser radiation is a pulsed laser radiation (L) comprising nanosecond pulses and a pulse duration of the laser radiation (L) is between 1 ns and at most 50 ns inclusive, wherein an optical path length difference between the partial beams (P) corresponds to at least 0.025 times and at most 0.25 times the pulse duration, and wherein an energy density of all the partial beams (P) together in the irradiation plane (10) is between 200 $mJ/cm^2$ and 850 $mJ/cm^2$ inclusive per pulse, and
wherein a mean roughness of a main side (30) of the carrier (3), said main side facing away from the semiconductor layer sequence (2), is between 0.1 $\mu$m and 5.0 $\mu$m inclusive,
**characterized by**:
- splitting a laser radiation (L) into at least two partial beams (P), and
- superimposing the partial beams (P) in an irradiation plane (10), in which is situated a main side (30) of the carrier (3), said main side facing away from the semiconductor layer sequence (2),
wherein an angle ($\alpha$) between the at least two partial beams (P) with respect to one another at the irradiation plane (10) is at least 1.0°.

10. Laser lift-off method according to the preceding claim,
wherein an energy density of all the partial beams (P) per pulse overall lies below a destruction threshold of a material of a decomposition zone (20) of the semiconductor layer sequence (2).

11. Laser lift-off method according to Claim 9 or 10,
wherein the carrier (3) comprises or consists of sapphire, and wherein the semiconductor layer sequence (2) is based on GaN, InGaN and/or AlGaN.

12. Laser lift-off method according to any of Claims 9 to 11,
wherein the carrier (3) has a thickness (T) of between 250 $\mu$m and 1.5 mm inclusive,
and wherein an intensity modulation of the superimposed partial beams (P) at a growth side (35) of the carrier (3), said growth side facing the semiconductor layer sequence (2), is at most 20%, relative to a local envelope (7) of a beam profile (8) of the superimposed partial beams (P).

13. Laser lift-off method according to any of Claims 9 to 12,
which is carried out by means of a device (100) according to any of Claims 1 to 8.

**Revendications**

1. Dispositif (100) pour un procédé d'enlèvement de matière par laser, destiné à retirer au moins une couche (2) d'un support (3) et présentant

   un laser qui forme un faisceau laser (L),

   le faisceau laser étant un faisceau laser (L) pulsé en impulsions de l'ordre des nanosecondes, la durée des impulsions du faisceau laser (L) étant comprise entre 1 ns et au plus 50 ns, ces valeurs incluses,

   la différence de longueur d'onde optique entre les parties (P) de faisceau correspondant au moins à 0,025 fois et au plus à 0,25 fois la durée des impulsions et la densité d'énergie de tous les faisceaux partiels (P) situés ensemble dans le plan d'irradiation (10) étant comprise entre 200 mJ/cm$^2$ et 850 mJ/cm$^2$ par impulsion, ces valeurs incluses, **caractérisé par** au moins un diviseur (4) de faisceau et en ce que

   le faisceau laser (L) est divisé en au moins deux faisceaux partiels (P) au moyen du ou des diviseurs (4) de faisceau,

   en ce que les deux ou plusieurs faisceaux partiels (P) sont superposés dans un plan d'irradiation (10),

   en ce que le plan d'irradiation (10) est prévu de telle sorte qu'un côté principal (30) du support (3) non tourné vers la couche (2) y sont situé et

   en ce que l'angle ($\alpha$) entre les deux ou plusieurs faisceaux partiels (P) sur le plan d'irradiation (10) est d'au moins 1,0°.

2. Dispositif (100) selon la revendication précédente, dans lequel tous les faisceaux partiels (P) présentent une même intensité avec une tolérance d'au plus 20 %.

3. Dispositif (100) selon l'une des revendications précédentes, dans lequel aucun composant optique prévu pour la transmission du rayonnement n'est situé dans les parcours des rayonnements partiels (P) entre le diviseur (4) de faisceau associé et le plan d'irradiation (10) de telle sorte que les faisceaux partiels (P) ne traversent pas de matière condensée à partir du diviseur (4) de faisceau associé jusqu'au plan d'irradiation (10).

4. Dispositif (100) selon l'une des revendications précédentes, dans lequel l'angle ($\alpha$) entre les faisceaux partiels (P) est compris entre 7,5° et 50°, ces valeurs incluses, et l'angle entre les faisceaux partiels (P) et la normale (11) au plan d'irradiation (10) est compris entre 0° et 50°, ces valeurs incluses, la durée des impulsions du faisceau laser (L) étant située entre 1 ns et 15 ns, ces valeurs incluses.

5. Dispositif (100) selon l'une des revendications précédentes, dans lequel le faisceau laser (L) est divisé en N faisceaux partiels (P) par N-1 diviseurs (4) de faisceau, avec pour la réflectivité R(N) du diviseur (4) de faisceau N :

$$R(N) = 1/(N+1),$$

   N étant un nombre entier compris entre 3 et 8, ces valeurs incluses, les diviseurs (4) de faisceau présentant une réflectivité croissante et étant disposés le long d'un parcours du faisceau conduisant au plan d'irradiation (10).

6. Dispositif (100) selon l'une des revendications précédentes, dans lequel les faisceaux partiels (P) ne traversent aucun composant optique (6) prévu pour la transmission du rayonnement entre le diviseur (4) de faisceau associé et le plan d'irradiation (10).

7. Dispositif (100) selon l'une des revendications précédentes, dans lequel les faisceaux partiels (P) présentent dans le plan d'irradiation (10) la même surface transversale et la même extension latérale avec une tolérance d'au plus 15 %.

8. Dispositif (100) selon l'une des revendications précédentes, dans lequel les faisceaux partiels (P) et le rayonnement laser (L) présentent des profils de faisceau en forme de courbe de Gauss d'un diamètre de 1/e$^2$ par rapport à la diminution d'intensité du rayonnement (L, P) dans la direction latérale et à une intensité maximale comprise entre 2 mm et 8 mm, ces valeurs incluses.

9. Procédé d'enlèvement de matière au laser prévu pour retirer une succession de couches semi-conductrices (2) obtenues par croissance épitactique d'un support (3), le procédé comportant les étapes qui consistent à :

   préparer la couche semi-conductrice (2) ou la succession (2) de couches semi-conductrices par croissance épitactique sur le support (3),

le faisceau laser étant un faisceau laser (L) pulsé en impulsions de l'ordre des nanosecondes, la durée des impulsions du faisceau laser (L) étant comprise entre 1 ns et au plus 50 ns, ces valeurs incluses,

la différence de longueur d'onde optique entre les parties (P) de faisceau correspondant au moins à 0,025 fois et au plus à 0,25 fois la durée des impulsions et la densité d'énergie de tous les faisceaux partiels (P) situés ensemble dans le plan d'irradiation (10) étant comprise entre 200 mJ/cm$^2$ et 850 mJ/cm$^2$ par impulsion, ces valeurs incluses,

la rugosité moyenne du côté principal (30) du support (3) non tourné vers la succession (2) de couches semi-conductrices étant comprise entre 0,1 $\mu$m et 5,0 $\mu$m, ces valeurs comprises,

**caractérisé par** les étapes qui consistent à :

diviser un rayonnement laser (L) en au moins deux faisceaux partiels (P),

superposer les faisceaux partiels (P) dans un plan d'irradiation (10) dans lequel un côté principal (30) du support (3) non tourné vers la succession (2) de couches semi-conductrices est situé,

l'angle ($\alpha$) entre les deux ou plusieurs faisceaux partiels (P) sur le plan d'irradiation (10) étant d'au moins 1,0°.

10. Procédé d'enlèvement de matière au laser selon la revendication précédente, dans lequel la densité d'énergie de tous les faisceaux partiels (P) par impulsion est située globalement en dessous du seuil de destruction d'un matériau d'une zone de décomposition (20) de la succession (2) de couches semi-conductrices.

11. Procédé d'enlèvement de matière au laser selon les revendications 9 ou 10, dans lequel le support (3) comporte du saphir ou en est constitué et dans lequel la succession (2) de couches semi-conductrices est à base de GaN, d'InGaN et/ou d'AlGaN.

12. Procédé d'enlèvement de matière au laser selon l'une des revendications 9 à 11, dans lequel le support (3) présente une épaisseur (T) comprise entre 250 $\mu$m et 1,5 mm et dans lequel la modulation d'intensité des faisceaux partiels (P) superposés sur un côté de croissance (35) du support (3) tourné vers la succession (2) de couches semi-conductrices vaut au plus 20 % par rapport à une enveloppe locale (7) d'un profil (8) des faisceaux partiels (P) superposés.

13. Procédé d'enlèvement de matière au laser selon l'une des revendications 9 à 12, exécuté avec un dispositif (100) selon l'une des revendications 1 à 8.

# FIG 1

# FIG 2

EP 2 509 741 B1

FIG 3

A)

B)

C)

FIG 4

FIG 5

FIG 6

A)

B)

## FIG 7

### A)

### B)

## FIG 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5786560 A
- US 20060246687 A1
- CN 2432001 Y
- US 20060246693 A1